(19) Europäisches Patentamt
European Patent Office
Office européen des brevets

(11) **EP 4 071 447 B1**

(12) **EUROPÄISCHE PATENTSCHRIFT**

(45) Veröffentlichungstag und Bekanntmachung des Hinweises auf die Patenterteilung:
**01.05.2024 Patentblatt 2024/18**

(21) Anmeldenummer: **22158486.5**

(22) Anmeldetag: **24.02.2022**

(51) Internationale Patentklassifikation (IPC):
**G01F 1/60** $^{(2006.01)}$     G01R 27/22 $^{(2006.01)}$

(52) Gemeinsame Patentklassifikation (CPC):
**G01F 1/60;** G01R 27/22

(54) **VERFAHREN ZUM BESTIMMEN DER LEITFÄHIGKEIT EINES MEDIUMS, BETRIEBSVERFAHREN EINES MAGNETISCH-INDUKTIVEN DURCHFLUSSMESSGERÄTS, UND MAGNETISCH-INDUKTIVES DURCHFLUSSMESSGERÄT**

METHOD FOR DETERMINING THE CONDUCTIVITY OF A MEDIUM, METHOD OF OPERATING A MAGNETIC-INDUCTIVE FLOWMETER, AND MAGNETIC-INDUCTIVE FLOWMETER

PROCÉDÉ DE DÉTERMINATION DE LA CONDUCTIVITÉ D'UN MILIEU, PROCÉDÉ DE FONCTIONNEMENT D'UN DÉBITMÈTRE À INDUCTION MAGNÉTIQUE, ET DÉBITMÈTRE À INDUCTION MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.03.2021 DE 102021105516**

(43) Veröffentlichungstag der Anmeldung:
**12.10.2022 Patentblatt 2022/41**

(73) Patentinhaber: **Krohne Messtechnik GmbH 47058 Duisburg (DE)**

(72) Erfinder:
• **Brockhaus, Helmut 46145 Oberhausen (DE)**
• **Dabrowski, Markus 47269 Duisburg (DE)**

(74) Vertreter: **Gesthuysen Patentanwälte Partnerschaftsgesellschaft mbB Huyssenallee 68 45128 Essen (DE)**

(56) Entgegenhaltungen:
**DE-A1- 10 243 748        DE-A1- 19 844 489 DE-A1-102007 014 469**

**Beschreibung**

Die Erfindung betrifft ein Verfahren zum Bestimmen einer Leitfähigkeit eines Mediums, ein Betriebsverfahren eines magnetisch-induktiven Durchflussmessgeräts und ein magnetisch-induktives Durchflussmessgerät.

Das Verfahren zum Bestimmen einer Leitfähigkeit eines Mediums benötigt eine Steuerung und eine Messzelle. Die Messzelle weist eine Zellkonstante, eine erste Elektrode und eine zweite Elektrode auf. Dabei sind die erste und die zweite Elektrode in unmittelbarem Kontakt mit dem Medium. Demnach handelt es sich bei der Messzelle um eine konduktive Messzelle. Die Steuerung ist eine Vorrichtung.

Konduktive Messzellen sind aus dem Stand der Technik hinreichend bekannt. Eine Leitfähigkeit $\sigma$ eines Mediums wird mit einer konduktiven Messzelle gemessen, indem ein elektrisches Signal S in die erste und die zweite Elektrode eingespeist wird, wodurch eine Spannung U über der ersten und der zweiten Elektrode abfällt und ein Strom I durch das Medium fließt. Aus der Spannung und dem Strom wird dann ein Widerstand R zwischen der ersten und zweiten Elektrode bestimmt und aus dem Widerstand wird unter Verwendung einer Zellkonstanten k der Messzelle die Leitfähigkeit des Mediums bestimmt. Die Bestimmung der Leitfähigkeit erfolgt dabei gemäß einer Formel

$$\sigma = \frac{k}{R}.$$

Das Betriebsverfahren des magnetisch-induktiven Durchflussmessgeräts benötigt eine Steuerung, ein Messrohr, eine erste Elektrode und eine zweite Elektrode. Dabei sind die erste und die zweite Elektrode am Messrohr in unmittelbarem Kontakt mit einem Medium im Messrohr angeordnet. Weiter ist die Steuerung zum Bestimmen eines Durchflusses des Mediums durch das Messrohr unter Verwendung der ersten und der zweiten Elektrode ausgebildet.

Das magnetisch-induktive Durchflussmessgerät weist eine Steuerung, ein Messrohr, eine erste Elektrode und eine zweite Elektrode auf. Dabei sind die erste und die zweite Elektrode derart am Messrohr angeordnet, sodass die erste und die zweite Elektrode im Betrieb des magnetisch-induktiven Durchflussmessgeräts in unmittelbarem Kontakt mit einem Medium im Messrohr sind. Die Steuerung ist zum Bestimmen eines Durchflusses des Mediums durch das Messrohr unter Verwendung der ersten und der zweiten Elektrode ausgebildet.

Magnetisch-induktive Durchflussmessgeräte sind aus dem Stand der Technik hinreichend bekannt. Ein magnetisch-induktives Durchflussmessgerät misst im Betrieb den Durchfluss eines Mediums durch das Messrohr. Ein Medium muss dafür eine elektrische Leitfähigkeit aufweisen. Ein magnetisch-induktives Durchflussmessgerät weist für gewöhnlich einen Elektromagneten auf, der derart eingerichtet ist, dass ein von ihm erzeugtes Magnetfeld das im Messrohr befindliche Medium zumindest teilweise durchsetzt und eine Strömung des Mediums im Messrohr eine Spannung in dem Medium induziert. Die Spannung wird mit der ersten und der zweiten Elektrode abgegriffen und ist proportional zu einer Strömungsgeschwindigkeit des Mediums im Messrohr. Aus der Strömungsgeschwindigkeit wird zum Beispiel unter Verwendung einer Innenquerschnittsfläche des Messrohrs ein Volumendurchfluss des Mediums durch das Messrohr oder unter zusätzlicher Verwendung einer Dichte des Mediums ein Massedurchfluss des Mediums durch das Messrohr bestimmt.

Zum Stand der Technik gehören insbesondere die folgenden Druckschriften. Die DE 198 44 489 A1 offenbart ein Verfahren zum Bestimmen einer elektrischen Leitfähigkeit von Flüssigkeiten mittels konduktiv betreibbarer Leitfähigkeitsmesszellen. Die DE 10 2007 014 469 A1 offenbart ein Verfahren zur vorausschauenden Wartung von einem magnetisch-induktiven Durchflussmessgerät und ein Verfahren zur Bestimmung einer elektrischen Leitfähigkeit mit einem magentisch-induktives Durchflussmessgerät. Die DE 102 43 748 A1 offenbart ein magnetisch-induktives Durchflussmessgerät mit einem Messrohr, welches im Messrohr hängen gebliebenes Isoliermaterial erfassen und zwischen zu messenden Fluiden unterscheiden kann.

Aus der Praxis der Bestimmung von Leitfähigkeiten von Medien mit konduktiven Meßzellen ist bekannt, dass eine Genauigkeit einer Bestimmung einer Leitfähigkeit eines Mediums abhängig von der tatsächlichen Leitfähigkeit des Mediums ist. Aufgabe der vorliegenden Erfindung ist daher, die Abhängigkeit der Genauigkeit der Bestimmung einer Leitfähigkeit eines Mediums von der tatsächlichen Leitfähigkeit des Mediums zu reduzieren, wodurch die Genauigkeit der Bestimmung der Leitfähigkeit des Mediums verbessert ist.

Die Aufgabe wird in Bezug auf das Verfahren zum Bestimmen einer Leitfähigkeit eines Mediums gemäß Anspruch 1 gelöst. Erfindungsgemäß führt die Steuerung die folgenden Schritte aus:
In einem Schritt wird ein Signal (S) mit einer ersten Frequenz ($f_1$) und einer zweiten Frequenz ($f_2$) erzeugt und in die erste und die zweite Elektrode eingespeist. Bei diesem Signal handelt es sich um ein elektrisches Signal, welches grundsätzlich nur die erste und die zweite Frequenz aufweist. Durch das Einspeisen des Signals in die erste und die zweite Elektrode liegt das Signal zwischen der ersten und der zweiten Elektrode und damit auch im Medium an.

In einem Schritt wird eine erste Spannung ($U_1$) zwischen der ersten und der zweiten Elektrode und ein erster Strom ($I_1$) durch das Medium für die erste Frequenz des Signals und eine erste Impedanz ($Z_1$) aus der ersten Spannung und dem ersten Strom bestimmt.

In einem Schritt wird eine zweite Spannung ($U_2$) zwischen der ersten und der zweiten Elektrode und ein zweiter Strom ($I_2$) durch das Medium für die zweite Frequenz des Signals und eine zweite Impedanz ($Z_2$) aus der zweiten Spannung und dem zweiten Strom bestimmt.

Eine Spannung und ein Strom, die bei einer Frequenz des Signals bestimmt werden, weisen grundsätzlich nur diese Frequenz auf, auch wenn das Signal weitere Frequenzen aufweisen sollte.

In einem Schritt werden eine Phase ($\varphi_1$) der ersten Impedanz und eine Phase ($\varphi_2$) der zweiten Impedanz bestimmt und miteinander verglichen. Die Impedanzen werden nach Betrag ($|Z_1|$, $|Z_2|$) und Phase ($\varphi_1$, $\varphi_2$) bzw. Realteil ($\mathrm{Re}(Z_1)$, $\mathrm{Re}(Z_2)$) und Imaginärteil ($\mathrm{Im}(Z_1)$, $\mathrm{Im}(Z_2)$) bestimmt.

In einem Schritt wird, wenn die Phase der ersten Impedanz kleiner als die Phase der zweiten Impedanz ist ($\varphi_1 < \varphi_2$), ein Widerstand (R) des Mediums gemäß einer ersten Formel

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)}$$

bestimmt.

In einem Schritt wird, wenn die Phase der ersten Impedanz gleich oder größer als die Phase der zweiten Impedanz ist ($\varphi_1 \geq \varphi_2$), der Widerstand gemäß einer zweiten Formel

$$R = \frac{|Z_1|}{\cos(\varphi_1)}$$

bestimmt.

Demnach stellen die beiden unmittelbar zuvor beschriebenen Schritte zueinander alternative Schritte dar, die in Abhängigkeit davon ausgeführt werden, wie das Verhältnis der Phase der ersten Impedanz zu der Phase der zweiten Impedanz ist.

In einem Schritt wird eine Leitfähigkeit des Mediums unter Verwendung des Widerstands und der Zellkonstanten bestimmt.

Durch das Bestimmen des Widerstands entweder gemäß der ersten oder der zweiten Formel in Abhängigkeit des Verhältnisses der Phase der ersten Impedanz zur Phase der zweiten Impedanz ist die Bestimmung der Leitfähigkeit genauer als aus dem Stand der Technik bekannt.

Die Erfindung beruht auf der Erkenntnis, dass der Verlauf der Phase der Impedanz über der Leitfähigkeit eines Mediums abhängig von der Frequenz des Signals ist ($\varphi = f(f,\sigma)$) und dass Abweichungen zwischen den Verläufen der Phasen bei unterschiedlichen Frequenzen des Signals ($\varphi_1 = f(f_1,\sigma)$, $\varphi_2 = f(f_2,\sigma)$) geeignet sind, eine geeignete Formel zur Bestimmung des Widerstands auszuwählen. Weiter beruht die Erfindung auf dem Auffinden der beiden geeigneten Formeln.

In einer Ausgestaltung des Verfahrens weist die Steuerung Leitungen auf, welche die Steuerung zum einen mit der ersten Elektrode und zum anderen mit der zweiten Elektrode verbinden. Wenn die Phase der ersten Impedanz nun kleiner als die Phase der zweiten Impedanz ist ($\varphi_1 < \varphi_2$), dann wird vom Widerstand ein Leitungswiderstand der Leitungen subtrahiert. Durch die zusätzliche Berücksichtigung des Leitungswiderstands wird die Genauigkeit der Bestimmung der Leitfähigkeit des Mediums weiter verbessert.

In einer weiteren Ausgestaltung weist das Signal ein erstes Teilsignal mit der ersten Frequenz und ein zweites Teilsignal mit der zweiten Frequenz auf. Demnach weist das erste Teilsignal die erste Frequenz und das zweite Teilsignal die zweite Frequenz auf. Weiter werden das erste und das zweite Teilsignal einander im Zeitbereich überlagert. Das bedeutet, dass das erste Teilsignal und das zweite Teilsignal zumindest in einem Intervall gleichzeitig auftreten. Die Überlagerung im Zeitbereich bewirkt, dass ein Zeitbedarf für das Ausführen des Verfahrens reduziert ist im Vergleich zur zeitlich aufeinanderfolgenden Einspeisung des ersten und des zweiten Teilsignals in die erste und die zweite Elektrode. Das erste und das zweite Teilsignal sind vorzugsweise jeweils grundsätzlich sinusförmig.

In einer weiteren Ausgestaltung liegt ein Quotient aus der zweiten Frequenz geteilt durch die erste Frequenz in einem Bereich zwischen 1,8 und 2,2. Bevorzugt liegt dieser Quotient in einem Bereich zwischen 1,9 und 2,1. Besonders bevorzugt ist dieser Quotient 2. Ein Quotient mit den vorstehend genannten Werten ist vorteilhaft, da Signale, wie zum Beispiel Spannungen und Ströme, mit Frequenzen mit einem solchen Abstand auf einfache Weise von der Steuerung voneinander zu unterscheiden sind. Für die Durchführung des Verfahrens ist es erforderlich, Signale gemäß ihren Frequenzen zu unterscheiden.

In einer Weiterbildung der vorstehenden Ausgestaltung liegt die erste Frequenz in einem Bereich zwischen 450 Hz und 550 Hz. Bevorzugt liegt die erste Frequenz in einem Bereich zwischen 480 Hz und 520 Hz. Besonders bevorzugt liegt diese Frequenz in einem Bereich zwischen 490 Hz und 510 Hz. Eine erste Frequenz mit diesen Werten ist vorteilhaft, da diese Werte auf einfache Weise zu erzeugen und zu verarbeiten sind. Zum Beispiel wird von der Steuerung als erste Frequenz 500 Hz und als Quotient 2 gewählt, weshalb die zweite Frequenz 1 kHz ist.

In einer weiteren Ausgestaltung des Verfahrens weist das Signal eine Signalspannung (U) und einen Signalstrom (I) auf. Weiter führt die Steuerung die folgenden Schritte aus:
In einem Schritt wird der Signalstrom in das Medium eingeprägt.

In einem Schritt wird die erste Spannung ($U_1$) bestimmt, indem ein erstes Rechtecksignal mit der ersten Frequenz erzeugt und das erste Rechtecksignal mit der Signalspannung multipliziert wird.

In einem Schritt wird die zweite Spannung ($U_2$) bestimmt, indem ein zweites Rechtecksignal mit der zweiten Frequenz erzeugt und das zweite Rechtecksignal mit der Signalspannung multipliziert wird.

Die erste Spannung weist, wie bereits ausgeführt worden ist, die erste Frequenz auf. Durch das Multiplizieren der ersten Spannung mit dem ersten Rechtecksignal, welches ebenfalls die erste Frequenz aufweist, wird die erste Spannung demnach gleichgerichtet. Die nachfolgenden Schritte erfolgen dann mit der gleich gerichteten Spannung. Entsprechend wird die zweite Spannung durch das Multiplizieren mit dem zweiten Rechtecksignal ebenfalls gleichgerichtet. Diese Ausgestaltung ist vorteilhaft, da sie ein einfaches Bestimmen der ersten und zweiten Spannung ermöglicht. Ein Bestimmen des ersten und des zweiten Stroms entfällt in so weit, als dass sie von der Steuerung eingeprägt werden und sie somit aus dem Vorgang der Erzeugung schon bestimmt sind. Diese Ausgestaltung ist besonders vorteilhaft, wenn sie mit einer Ausgestaltung kombiniert wird, bei welcher das erste Teilsignal und das zweite Teilsignal einander im Zeitbereich überlagert werden. Denn dann ist sowohl der Zeitbedarf für ein Ausführen des Verfahrens gering als auch ein Aufwand zum Bestimmen der ersten und zweiten Spannung.

Die Aufgabe wird in Bezug auf das Betriebsverfahren eines magnetisch-induktiven Durchflussmessgeräts gemäß Anspruch 7 gelöst. Erfindungsgemäß wird von der ersten Elektrode, der zweiten Elektrode und dem Messrohr eine Messzelle mit einer Zellkonstanten zum Bestimmen einer Leitfähigkeit des Mediums gebildet. Demnach weist das magnetisch-induktive Durchflussmessgerät implizit eine zuvor beschriebene konduktive Messzelle auf. Weiter führt die Steuerung erfindungsgemäß die folgenden Schritte aus:
In einem Schritt wird ein Signal (S) mit einer ersten Frequenz ($f_1$) und einer zweiten Frequenz ($f_2$) erzeugt und in die erste und die zweite Elektrode eingespeist.

In einem Schritt wird eine erste Spannung ($U_1$) zwischen der ersten und der zweiten Elektrode und ein erster Strom ($I_1$) durch das Medium für die erste Frequenz des Signals und eine erste Impedanz ($Z_1$) aus der ersten Spannung und dem ersten Strom bestimmt.

In einem Schritt wird eine zweite Spannung ($U_2$) zwischen der ersten und der zweiten Elektrode und ein zweiter Strom ($I_2$) durch das Medium für die zweite Frequenz des Signals und eine zweite Impedanz ($Z_2$) aus der zweiten Spannung und dem zweiten Strom bestimmt.

In einem Schritt werden eine Phase ($\varphi_1$) der ersten Impedanz und eine Phase ($\varphi_2$) der zweiten Impedanz bestimmt und miteinander verglichen.

In einem Schritt wird, wenn die Phase der ersten Impedanz kleiner als die Phase der zweiten Impedanz ist ($\varphi_1 < \varphi_2$), ein Widerstand (R) des Mediums gemäß einer ersten Formel

$$R = \operatorname{Re}(Z_2) - \operatorname{Im}(Z_2) \cdot \frac{\operatorname{Re}(Z_2) - \operatorname{Re}(Z_1)}{\operatorname{Im}(Z_2) - \operatorname{Im}(Z_1)}$$

bestimmt.

In einem Schritt wird, wenn die Phase der ersten Impedanz gleich oder größer als die Phase der zweiten Impedanz ist ($\varphi_1 \geq \varphi_2$), des Widerstands gemäß einer zweiten Formel

$$R = \frac{|Z_1|}{\cos(\varphi_1)}$$

bestimmt.

In einem Schritt wird eine Leitfähigkeit des Mediums unter Verwendung des Widerstands und der Zellkonstanten bestimmt.

Demnach sind grundsätzlich keine baulichen Veränderung am magnetisch-induktiven Durchflussmessgerät notwendig, um das Betriebsverfahren umzusetzen.

In einer Ausgestaltung des Betriebsverfahrens wird von der Steuerung ein Durchfluss des Mediums durch das Messrohr durch Ausführen eines magnetisch-induktiven Durchflussmessverfahrens unter Verwendung der ersten und der zweiten Elektrode bestimmt und wird. Magnetisch-induktive Durchflussmessverfahren sind aus dem Stand der Technik hinlänglich bekannt. Hier werden jedoch die erste und die zweite Elektrode zum einen zum Durchführen eines magnetisch-induktiven Durchflussmessverfahrens zur Bestimmung eines Durchflusses eines Mediums durch das Messrohr und zum anderen bei dem Verfahren zum Bestimmen der Leitfähigkeit des Mediums im Messrohr verwendet. Ein Vorteil dieser Ausgestaltung ist ganz offensichtlich, dass keine weiteren Sensoren, wie z. B. weitere Elektroden, benötigt werden, wodurch die Kosten reduziert sind. Weitere Elektroden in unmittelbarem Kontakt mit dem Medium würden auch die Wahrscheinlichkeit einer Leckage eines Mediums im Messrohr erhöhen.

In einer Weiterbildung der vorstehenden Ausgestaltung wird beim magnetisch-induktiven Durchflussmessverfahren von der Steuerung ein magnetisches Wechselfeld zum Bestimmen des Durchflusses erzeugt. Vorzugsweise ist das magnetische Wechselfeld ein Rechteck-Wechselfeld. Dabei wird von der Steuerung das Signal (S) in einem transienten Bereich des magnetischen Wechselfelds in die erste und die zweite Elektrode eingespeist. Ein Vorteil der Verwendung eines magnetischen Wechselfelds ist, dass durch ein solches Störungen auf die Bestimmung des Durchflusses reduziert werden, wodurch eine Genauigkeit der Bestimmung des Durchflusses verbessert ist. Ein transienter Bereich des magnetischen Wechselfelds ist dadurch gekennzeichnet, dass in diesem keine durch ein Strömen eines Mediums in die erste und zweite Elektrode induzierte Spannung zur Bestimmung des Durchflusses des Mediums bestimmt wird. Ein Vorteil dieser Weiterbildung ist demnach, dass das magnetisch-induktiven Durchflussmessverfahren nicht durch das Verfahren zum Bestimmen der Leitfähigkeit des Mediums beeinträchtigt oder eine Zeitdauer beim Ausführen des Betriebsverfahrens vergrößert wird. Oftmals sind keine Änderungen an einem magnetisch-induktiven Durchflussmessverfahren notwendig, wenn zusätzlich das Verfahren zum Bestimmen der Leitfähigkeit des Mediums implementiert wird.

In einer weiteren Ausgestaltung weist die Steuerung Leitungen auf, welche die Steuerung zum einen mit der ersten Elektrode und zum anderen mit der zweiten Elektrode verbinden. Vorzugsweise wird von der Steuerung des magnetisch-induktiven Durchflussmessgeräts eines der zuvor beschriebenen Verfahren ausgeführt.

Im Übrigen gelten die Ausführungen zum Verfahren entsprechend für das Betriebsverfahren und umgekehrt.

Die Aufgabe wird in Bezug auf das magnetisch-induktive Durchflussmessgerät gemäß Anspruch 11 gelöst. Erfindungsgemäß bilden die erste Elektrode, die zweite Elektrode und das Messrohr eine Messzelle mit einer Zellkonstanten zum Bestimmen einer Leitfähigkeit des Mediums. Demnach weist das magnetisch-induktive Durchflussmessgerät implizit eine zuvor beschriebene konduktive Messzelle auf. Weiter führt die Steuerung erfindungsgemäß die folgenden Schritte aus:

In einem Schritt wird ein Signal (S) mit einer ersten Frequenz ($f_1$) und einer zweiten Frequenz ($f_2$) erzeugt und in die erste und die zweite Elektrode eingespeist.

In einem Schritt wird eine erste Spannung ($U_1$) zwischen der ersten und der zweiten Elektrode und ein erster Strom ($I_1$) durch das Medium für die erste Frequenz des Signals und eine erste Impedanz ($Z_1$) aus der ersten Spannung und dem ersten Strom bestimmt.

In einem Schritt wird eine zweite Spannung ($U_2$) zwischen der ersten und der zweiten Elektrode und ein zweiter Strom ($I_2$) durch das Medium für die zweite Frequenz des Signals und eine zweite Impedanz ($Z_2$) aus der zweiten Spannung und dem zweiten Strom bestimmt.

In einem Schritt werden eine Phase ($\varphi_1$) der ersten Impedanz und eine Phase ($\varphi_2$) der zweiten Impedanz bestimmt und miteinander verglichen.

In einem Schritt wird, wenn die Phase der ersten Impedanz kleiner als die Phase der zweiten Impedanz ist ($\varphi_1 < \varphi_2$), ein Widerstand (R) des Mediums gemäß einer ersten Formel

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)}$$

bestimmt.

In einem Schritt wird, wenn die Phase der ersten Impedanz gleich oder größer als die Phase der zweiten Impedanz ist ($\varphi_1 \geq \varphi_2$), des Widerstands gemäß einer zweiten Formel

$$R = \frac{|Z_1|}{\cos(\varphi_1)}$$

bestimmt.

Demnach stellen die beiden unmittelbar zuvor beschriebenen Schritte zueinander alternative Schritte dar, die in Abhängigkeit davon ausgeführt werden, wie das Verhältnis der Phase der ersten Impedanz zu der Phase der zweiten Impedanz ist.

In einem Schritt wird eine Leitfähigkeit des Mediums unter Verwendung des Widerstands und der Zellkonstanten bestimmt.

In einer Ausgestaltung des magnetisch-induktiven Durchflussmessgeräts weist die Steuerung Leitungen auf, welche die Steuerung zum einen mit der ersten Elektrode und zum anderen mit der zweiten Elektrode verbinden. Vorzugsweise ist die Steuerung ausgebildet, eines der zuvor beschriebenen Verfahren und/oder Betriebsverfahren auszuführen.

Im Übrigen gelten die Ausführungen zum Verfahren und Betriebsverfahren entsprechend für das magnetisch-induktive Durchflussmessgerät und umgekehrt.

Im Einzelnen ist eine Vielzahl von Möglichkeiten gegeben, dass Verfahren zum Bestimmen einer Leitfähigkeit eines Mediums, dass Verfahren zum Betreiben eines magnetisch-induktiven Durchflussmessgeräts und das magnetisch-induktive Durchflussmessgerät auszugestalten und weiterzubilden. Dazu wird verwiesen sowohl auf die den unabhängigen Ansprüchen nachgeordneten Ansprüche als auch auf die nachfolgende Beschreibung eines bevorzugten Ausführungsbeispiels in Verbindung mit der Zeichnung. Die Zeichnung zeigt

Fig. 1    ein Ausführungsbeispiel eines magnetisch-induktiven Durchflussmessgeräts,

Fig. 2    Signalverläufe über der Zeit des magnetisch-induktiven Durchflussmessgeräts und

Fig. 3    ein elektrisches Ersatzschaltbild eines Mediums und

Fig. 4    Verläufe von Phasen von Impedanzen bei zwei unterschiedlichen Frequenzen eines Signals über einer Leitfähigkeit eines Mediums.

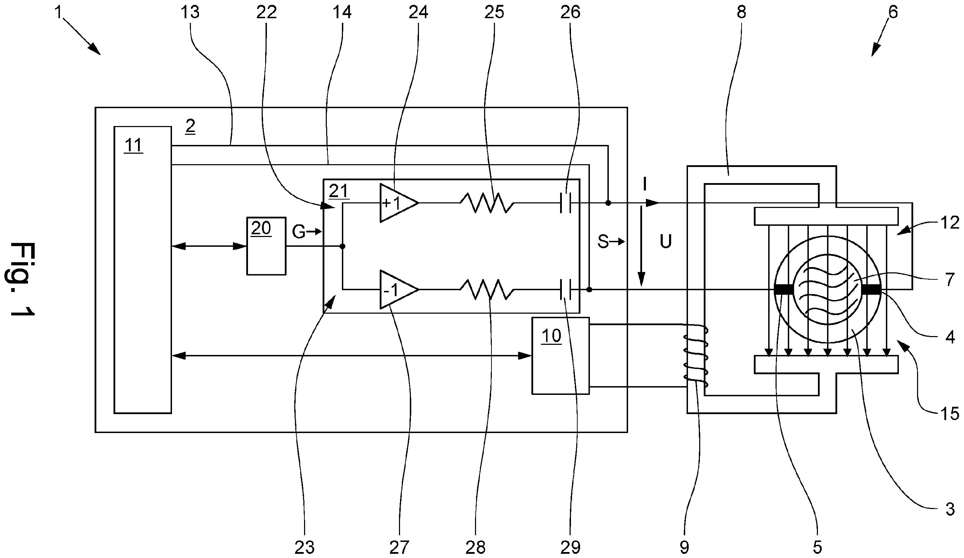

Figur 1 zeigt ein Ausführungsbeispiel eines magnetisch-induktiven Durchflussmessgeräts 1 im Betrieb beim Ausführen eines Betriebsverfahrens. Das magnetisch-induktives Durchflussmessgerät 1 weist eine Steuerung 2, ein Messrohr 3, eine erste Elektrode 4, eine zweite Elektrode 5 und einen Elektromagneten 6 auf. Ein Medium 7, welches eine elektrische Leitfähigkeit aufweist, strömt durch das Messrohr 3. Die erste Elektrode 4 und die zweite Elektrode 5 sind derart am Messrohr 3 angeordnet, dass die erste Elektrode 4 und die zweite Elektrode 5 in unmittelbarem Kontakt mit dem Medium 7 im Messrohr 3 sind.

Der Elektromagnet 6 weist ein Joch 8 und eine um das Joch 8 angeordnete Spule 9 auf. Die Spule 9 wird von einem Treiber 10 getrieben und der Treiber 10 wird von einem Mikrocontroller 11 gesteuert, was in Figur 1 durch einen Doppelpfeil angedeutet ist. Der Treiber 10 und der Mikrocontroller 11 sind in der Steuerung 2 angeordnet. Der Elektromagnet 6 ist derart eingerichtet, dass ein von ihm erzeugtes Magnetfeld 12, welches in Figur 1 durch eine Mehrzahl von parallelen Pfeilen angedeutet ist und eine magnetische Flussdichte B aufweist, das im Messrohr 3 befindliche Medium 7 teilweise durchsetzt und die Strömung des Mediums 7 im Messrohr 3 eine Spannung in dem Medium 7 induziert, die zwischen der ersten Elektrode 4 und der zweiten Elektrode 5 abgreifbar ist. Die induzierte Spannung ist proportional zu einer Strömungsgeschwindigkeit des Mediums 7 im Messrohr 3.

Die Steuerung 2 weist eine erste Leitung 13 und eine zweite Leitung 14 auf, wobei die erste Leitung 13 den Mikrocontroller 11 mit der ersten Elektrode 4 und die zweite Leitung 14 den Mikrocontroller 11 mit der zweiten Elektrode 5 verbindet, sodass die induzierte Spannung am Mikrocontroller 11 anliegt. Der Mikrocontroller 11 ist ausgebildet, die induzierte Spannung auszuwerten. Die erste Leitung 13 und die zweite Leitung 14 weisen zusammen einen Leitungswiderstand $R_L$ auf. In diesem Sinn ist die Steuerung 2 mit der ersten Leitung 13 und mit der zweiten Leitung 14 verbunden.

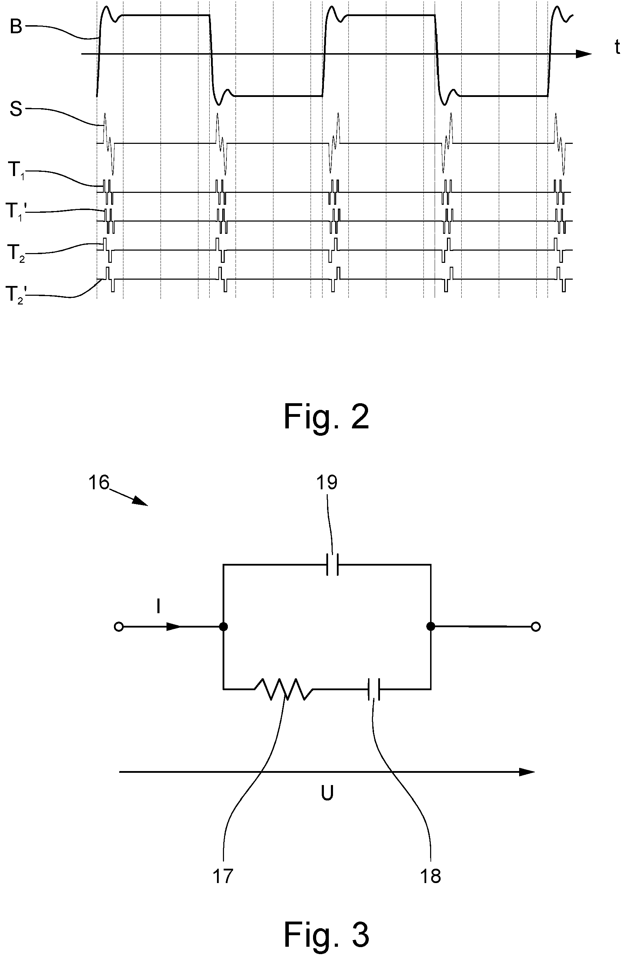

Die Steuerung 2 ist zum Bestimmen eines Durchflusses des Mediums 7 durch das Messrohr 3 unter Verwendung der ersten Elektrode 4 und der zweiten Elektrode 5 im Rahmen des Betriebsverfahrens ausgebildet. Vorliegend ist das Betriebsverfahren derart ausgestaltet, dass von der Steuerung 2 ein Durchfluss des Mediums 7 durch das Messrohr 3 durch Ausführen eines magnetisch-induktiven Durchflussmessverfahrens unter Verwendung der ersten Elektrode 4 und der zweiten Elektrode 5 bestimmt wird. Bei dem magnetisch-induktiven Durchflussmessverfahren wird von der Steuerung 2 ein magnetisches Rechteck-Wechselfeld mit der magnetischen Flussdichte B zum Bestimmen des Durchflusses erzeugt. Dabei steuert der Mikrocontroller 11 den Treiber 10 derart an, sodass sich das magnetische Rechteck-Wechselfeld einstellt. Der Verlauf der magnetischen Flussdichte B des magnetischen Rechteck-Wechselfelds über der Zeit t ist in der ersten Zeile des Diagramms in Figur 2 dargestellt. Aufeinanderfolgende konstante Bereiche magnetischen Flussdichte B sind durch transiente Bereiche miteinander verbunden. Aus der induzierten Spannung wird von dem Mikrocontroller 11 zunächst eine Strömungsgeschwindigkeit des Mediums 7 im Messrohr 3 bestimmt und dann aus der Strömungsgeschwindigkeit unter Verwendung einer Innenquerschnittsfläche des Messrohrs 3 ein Volumendurchfluss des Mediums 7 durch das Messrohr 3.

Die erste Elektrode 4, die zweite Elektrode 5 und ein Abschnitt des Messrohrs 3 bilden eine konduktive Messzelle 15 mit einer Zellkonstanten k zum Bestimmen einer Leitfähigkeit σ des Mediums 7. Die Bestimmung einer Leitfähigkeit σ des Mediums 7 erfolgt dabei gemäß der Formel

$$\sigma = \frac{k}{R}.$$

Figur 2 zeigt ein elektrisches Ersatzschaltbild 16 für das Medium 7 zwischen der ersten Elektrode 4 und der zweiten Elektrode 5. Das Ersatzschaltbild 16 ist eine Näherung des Mediums 3 für Wechselsignale. Das Ersatzschaltbild 16 weist eine Parallelschaltung aus einer Reihenschaltung und einem Parallelkondensator 17 auf. Die Reihenschaltung weist einen Mediumwiderstand 18 mit dem Widerstand R und einen Serienkondensator 19 auf. Unter Verwendung des Widerstands R und der Zellkonstanten k wird gemäß der obigen Formel die Leitfähigkeit σ bestimmt. Der Widerstand R ist also ein Widerstand des Mediums 7 zwischen der ersten Elektrode 4 und der zweiten Elektrode 5.

Die Steuerung 2 weist einen Sinusgenerator 20 und eine Ansteuerung 21 zum Einspeisen eines elektrischen Signals S in die erste Elektrode 4 und die zweite Elektrode 5 auf. Der Sinusgenerator 20 wird von dem Mikrocontroller 11 gesteuert, was durch einen Doppelpfeil in Figur 1 angedeutet ist, und ist zum Erzeugen eines Generatorsignals G mit zumindest einer ersten Frequenz $f_1$ und einer zweiten Frequenz $f_2$ ausgebildet. Die Ansteuerung 21 weist einen ersten Zweig 22 und einen zweiten Zweig 23 auf, in welche im Betrieb das Generatorsignal G eingespeist wird. Der erste Zweig 22 mündet in die erste Leitung 13 und der zweite Zweig mündet in die zweite Leitung 14. Der erste Zweig 22 weist eine Reihenschaltung mit einem ersten Verstärker 24, einem ersten Widerstand 25 und einem ersten Kondensator 26 auf. Der erste Verstärker 24 hat eine Verstärkung von +1. Der erste Widerstand 25 und der erste Kondensator 26 bilden einen ersten Hochpass. Der zweite Zweig 23 weist einen zweiten Verstärker 27, einen zweiten Widerstand 28 und einen zweiten Kondensator 29 auf. Der zweite Verstärker 27 hat eine Verstärkung von -1. Der zweite Widerstand 28 und der zweite Kondensator 29 bilden einen zweiten Hochpass. Während der erste Verstärker 24 das Generatorsignal G nur puffert, wird es vom zweiten Verstärker 27 zusätzlich noch invertiert. Das Signal S weist eine Signalspannung U und einen Signalstrom I auf. Die Ansteuerung 21 erzeugt aus dem Generatorsignal G das Signal S, welches ein differenzielles Signal ist.

Eine Grenzfrequenz des ersten Hochpasses und eine Grenzfrequenz des zweiten Hochpasses sind derart gewählt, dass keine wesentliche Dämpfung des Signals S erfolgt. Diese Hochpässe dienen dazu, ein Einspeisen eines Gleichsignals in die erste Elektrode 4 und in die zweite Elektrode 5 zu verhindern. Die Werte des ersten Widerstands 25 und des zweiten Widerstands 28 sind derart gewählt, dass der Widerstand R vernachlässigbar bei einer näherungsweisen Bestimmung des Signalstroms I ist. Und zwar wird der Signalstrom I vom Mikrocontroller 11, also von der Steuerung 2, bestimmt, indem eine Spannung des Generatorsignals G durch den halben Wert der Summe der Werte des ersten Widerstands 25 und des zweiten Widerstands 26 dividiert wird. Die näherungsweise Bestimmung des Signalstroms umfasst Betrag und Phase und ist für die beschriebenen Verfahren ausreichend genau.

Zusätzlich zu dem zuvor beschriebenen magnetisch-induktiven Durchflussmessverfahren führt die Steuerung 2 im Rahmen des Betriebsverfahrens noch die folgenden Schritte aus, zu deren Ausführung sie auch ausgebildet ist: In einem Schritt wird das Signal S mit einer ersten Frequenz $f_1$ = 500 Hz und einer zweiten Frequenz $f_2$ = 1 kHz erzeugt und in die erste Elektrode 4 und die zweite Elektrode 5 eingespeist. Das Einspeisen des Signals S erfolgt vorliegend durch ein Einprägen des Signalstroms I in das Medium 7 über die erste Elektrode 4 und die zweite Elektrode 5. Ein Quotient aus der zweiten Frequenz $f_2$ geteilt durch die erste Frequenz $f_1$ ist 2. Dazu wird von dem Sinusgenerator 20 zunächst das Generatorsignal G erzeugt, welches sowohl die erste Frequenz $f_1$ als auch die zweite Frequenz $f_2$ aufweist. Das Generatorsignal G wird dann in den ersten Zweig 22 und den zweiten Zweig 23 der Ansteuerung 21 eingespeist. Die Ansteuerung 21 erzeugt aus dem Generatorsignal G dann das Signal S, welches in die erste Elektrode 4 und in die zweite Elektrode 5 eingespeist wird.

Das Signal S weist ein erstes Teilsignal mit der ersten Frequenz $f_1$ und ein zweites Teilsignal mit der zweiten Frequenz $f_2$ auf. Das erste Teilsignal und das zweite Teilsignal sind einander zeitlich überlagert. Die zweite Zeile in Figur 2 zeigt das Signal S mit den beiden zeitlich überlagerten Teilsignal. Das Signal S wird nur in transienten Bereichen des magnetischen Wechselfeld B in die erste Elektrode 4 und die zweite Elektrode 5 eingespeist. Dadurch wird die Bestimmung des Durchflusses nicht beeinträchtigt. Weder leidet die Qualität noch steigt die Dauer der Bestimmung des Durchflusses.

In einem Schritt wird eine erste Spannung $U_1$ zwischen der ersten Elektrode 4 und der zweiten Elektrode 5 und ein erster Strom $I_1$ durch das Medium 7 für die erste Frequenz $f_1$ des Signals S und eine erste Impedanz $Z_1$ aus der ersten Spannung $U_1$ und dem ersten Strom $I_1$ bestimmt. Zu diesem Schritt gehört ein Teilschritt, in welchem die erste Spannung $U_1$ bestimmt wird, indem ein erstes Rechtecksignal $T_1$ mit der ersten Frequenz $f_1$ erzeugt und das erste Rechtecksignal $T_1$ mit der Signalspannung U multipliziert wird. Zum ersten Rechtecksignal $T_1$ gehört auch eine Kopie

$T_1'$ des ersten Rechtecksignals $T_1$, die eine Phasenverschiebung in Bezug auf das erste Rechtecksignal $T_1$ aufweist, vorzugsweise um 90°. Das erste Rechtecksignal $T_1$ ist in Zeile 3 und seine Kopie $T_1'$ ist in Zeile 4 von Figur 2 dargestellt. Demnach werden sowohl das erste Rechtecksignal $T_1$ als auch seine Kopie $T_1'$ mit der Signalspannung U multipliziert, sodass die Spannung $U_1$ nach Betrag und Phase bestimmt wird. Der erste Strom $I_1$ wird gemäß der zuvor beschriebenen näherungsweisen Bestimmung bestimmt, und zwar ebenfalls nach Betrag und Phase. Die erste Impedanz $Z_1$ wird ebenfalls nach Betrag und Phase $\varphi_1$ bestimmt.

In einem Schritt wird eine zweite Spannung $U_2$ zwischen der ersten Elektrode 4 und der zweiten Elektrode 5 und ein zweiter Strom $I_2$ durch das Medium 7 für die zweite Frequenz $f_2$ des Signals S und eine zweite Impedanz $Z_2$ aus der zweiten Spannung $U_2$ und dem zweiten Strom $I_2$ bestimmt. Auch zu diesem Schritt gehört ein Teilschritt, in welchem die zweite Spannung $U_2$ bestimmt wird, indem ein zweites Rechtecksignal $T_2$ mit der zweiten Frequenz $f_2$ erzeugt und das zweite Rechtecksignal $T_2$ mit der Signalspannung U multipliziert wird. Zum zweiten Rechtecksignal $T_2$ gehört auch eine Kopie $T_2'$ des zweiten Rechtecksignals $T_2$, die eine Phasenverschiebung in Bezug auf das zweite Rechtecksignal $T_2$ aufweist, vorzugsweise um 90°. Das zweite Rechtecksignal $T_2$ ist in Zeile 5 und seine Kopie $T_2'$ ist in Zeile 6 von Figur 2 dargestellt. Demnach werden sowohl das zweite Rechtecksignal $T_2$ als auch seine Kopie $T_2'$ mit der Signalspannung U multipliziert, sodass die Spannung $U_2$ nach Betrag und Phase bestimmt wird. Der zweite Strom $I_2$ wird gemäß der zuvor beschriebenen näherungsweisen Bestimmung bestimmt, und zwar ebenfalls nach Betrag und Phase. Die zweite Impedanz $Z_2$ wird ebenfalls nach Betrag und Phase $\varphi_2$ bestimmt.

In einem Schritt werden die Phase $\varphi_1$ der ersten Impedanz $Z_1$ und die Phase $\varphi_2$ der zweiten Impedanz $Z_2$ nach deren Bestimmung miteinander verglichen.

In einem Schritt wird, wenn die Phase $\varphi_1$ der ersten Impedanz $Z_1$ kleiner als die Phase $\varphi_2$ der zweiten Impedanz $Z_1$ ist, also $\varphi_1 < \varphi_2$ ist, der Widerstand R des Mediums gemäß der ersten Formel

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)} - R_L$$

bestimmt. In der ersten Formel wird zusätzlich der Leitungswiderstand $R_L$ subtrahiert.

In einem Schritt wird, wenn die Phase $\varphi_1$ der ersten Impedanz $Z_1$ gleich oder größer als die Phase $\varphi_2$ der zweiten Impedanz $Z_2$ ist, also $\varphi_1 \geq \varphi_2$ ist, der Widerstand R gemäß der zweiten Formel

$$R = \frac{|Z_1|}{\cos(\varphi_1)}$$

bestimmt.

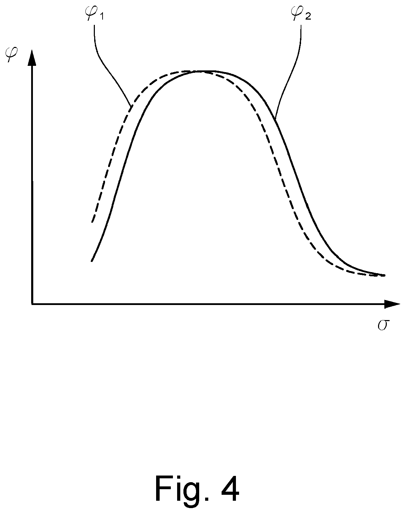

Die beiden unmittelbar zuvor beschriebenen Schritte stellen zueinander alternative Schritte dar, die in Abhängigkeit davon ausgeführt werden, wie das Verhältnis der Phase $\varphi_1$ der ersten Impedanz $Z_1$ zu der Phase $\varphi_2$ der zweiten Impedanz $Z_2$ ist. Aus Figur 4 ist die Eignung der Phase der Impedanz als Auswahlkriteriums für die erste oder zweite Formel ersichtlich. Sie zeigt zum einen einen Verlauf der Phase $\varphi_1$ der ersten Impedanz $Z_1$ über der Leitfähigkeit $\sigma$ und zum anderen einen Verlauf der Phase $\varphi_2$ der zweiten Impedanz $Z_2$ über der Leitfähigkeit $\sigma$.

In einem Schritt wird die Leitfähigkeit $\sigma$ des Mediums 7 unter Verwendung des Widerstands R und der Zellkonstanten k gemäß der Formel

$$\sigma = \frac{k}{R}$$

bestimmt.


**Patentansprüche**

1.  Verfahren zum Bestimmen einer Leitfähigkeit ($\sigma$) eines Mediums (7) mit einer Steuerung (2) und einer Messzelle (15),

    wobei die Messzelle (15) eine Zellkonstante (k), eine erste Elektrode (4) und eine zweite Elektrode (5) aufweist,
    wobei die erste Elektrode (4) und die zweite Elektrode (5) in unmittelbarem Kontakt mit dem Medium (7) sind und

wobei die Steuerung (2) die folgenden Schritte ausführt:

- Erzeugen eines Signals (S) mit einer ersten Frequenz ($f_1$) und einer zweiten Frequenz ($f_2$) und einspeisen des Signals (S) in die erste Elektrode (4) und die zweite Elektrode (5),
- bestimmen einer ersten Spannung ($U_1$) zwischen der ersten Elektrode (4) und der zweiten Elektrode (5) und eines ersten Stroms ($I_1$) durch das Medium (7) für die erste Frequenz ($f_1$) des Signals (S) und einer ersten Impedanz ($Z_1$) aus der ersten Spannung ($U_1$) und dem ersten Strom ($I_1$),
- bestimmen einer zweiten Spannung ($U_2$) zwischen der ersten Elektrode (4) und der zweiten Elektrode (5) und eines zweiten Stroms ($I_2$) durch das Medium (7) für die zweite Frequenz ($f_2$) des Signals (S) und einer zweiten Impedanz ($Z_2$) aus der zweiten Spannung ($U_2$) und dem zweiten Strom ($U_2$),
- bestimmen und vergleichen einer Phase ($\varphi_1$) der ersten Impedanz($Z_1$) mit einer Phase ($\varphi_2$) der zweiten Impedanz ($Z_2$),
- bestimmen, wenn die Phase ($\varphi_1$) der ersten Impedanz ($Z_1$) kleiner als die Phase ($\varphi_2$) der zweiten Impedanz ($Z_2$) ist, eines Widerstands (R) des Mediums (7) gemäß einer ersten Formel

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)},$$

- bestimmen, wenn die Phase ($\varphi_1$) der ersten Impedanz ($Z_1$) gleich der oder größer als die Phase ($\varphi_2$) der zweiten Impedanz ($Z_2$) ist, des Widerstands (R) gemäß einer zweiten Formel

$$R = \frac{|Z_1|}{\cos(\varphi_1)}$$

und
- bestimmen einer Leitfähigkeit ($\sigma$) des Mediums (7) unter Verwendung des Widerstands (R) und der Zellkonstanten (k).

2. Verfahren nach Anspruch 1, wobei die Steuerung (2) Leitungen (13, 14) aufweist, wobei die Leitungen (13, 14) die Steuerung (2) mit der ersten Elektrode (4) und der zweiten Elektrode (5) verbinden, wobei, wenn die Phase ($\varphi_1$) der ersten Impedanz ($Z_1$) kleiner als die Phase ($\varphi_2$) der zweiten Impedanz ($Z_2$) ist, vom Widerstand (R) ein Leitungswiderstand ($R_L$) der Leitungen (13, 14) subtrahiert wird.

3. Verfahren nach Anspruch 1 oder 2, wobei das Signal (S) ein erstes Teilsignal mit der ersten Frequenz ($f_1$) und ein zweites Teilsignal mit der zweiten Frequenz ($f_2$) aufweist und wobei das erste Teilsignal und das zweite Teilsignal einander im Zeitbereich überlagert werden.

4. Verfahren nach einem der Ansprüche 1 bis 3, wobei ein Quotient aus der zweiten Frequenz ($f_2$) geteilt durch die erste Frequenz ($f_1$) in einem Bereich zwischen 1,8 und 2,2, bevorzugt in einem Bereich zwischen 1,9 und 2,1 liegt und besonders bevorzugt 2 ist.

5. Verfahren nach Anspruch 4, wobei die erste Frequenz ($f_1$) in einem Bereich zwischen 450 Hz und 550 Hz, bevorzugt in einem Bereich zwischen 480 Hz und 520 Hz, besonders bevorzugt in einem Bereich zwischen 490 Hz und 510 Hz liegt.

6. Verfahren nach einem der Ansprüche 1 bis 5, wobei das Signal (S) eine Signalspannung (U) und einen Signalstrom (I) aufweist und wobei die Steuerung (2) die folgenden Schritte ausführt:

- Einprägen des Signalstroms in das Medium (7),
- bestimmen der ersten Spannung ($U_1$), indem ein erstes Rechtecksignal ($T_1$, $T_1'$) mit der ersten Frequenz ($f_1$) erzeugt und das erste Rechtecksignal ($T_1$, $T_1'$) mit der Signalspannung (U) multipliziert wird und
- bestimmen der zweiten Spannung ($U_2$), indem ein zweites Rechtecksignal ($T_2$, $T2'$) mit der zweiten Frequenz ($f_2$) erzeugt und das zweite Rechtecksignal ($T_2$, $T2'$) mit der Signalspannung (U) multipliziert wird.

**7.** Betriebsverfahren eines magnetisch-induktiven Durchflussmessgeräts (1) mit einer Steuerung (2), einem Messrohr (3), einer ersten Elektrode (4) und einer zweiten Elektrode (5),

wobei die erste Elektrode (4) und die zweite Elektrode (5) am Messrohr (3) in unmittelbarem Kontakt mit einem Medium (7) im Messrohr (3) angeordnet sind,

wobei die Steuerung (2) zum Bestimmen eines Durchflusses des Mediums (7) durch das Messrohr (3) unter Verwendung der ersten Elektrode (4) und der zweiten Elektrode (5) ausgebildet ist,

wobei die erste Elektrode (4), die zweite Elektrode (5) und das Messrohr (3) eine Messzelle (15) mit einer Zellkonstanten (k) zum Bestimmen einer Leitfähigkeit ($\sigma$) des Mediums (7) bilden und wobei die Steuerung (2) die folgenden Schritte ausführt:

- Erzeugen eines Signals (S) mit einer ersten Frequenz ($f_1$) und einer zweiten Frequenz ($f_2$) und einspeisen des Signals (S) in die erste Elektrode (4) und die zweite Elektrode (5),
- bestimmen einer ersten Spannung ($U_1$) zwischen der ersten Elektrode (4) und der zweiten Elektrode (4) und eines ersten Stroms ($I_1$) durch das Medium (7) für die erste Frequenz ($f_1$) des Signals (S) und einer ersten Impedanz ($Z_1$) aus der ersten Spannung ($U_1$) und dem ersten Strom ($I_1$),
- bestimmen einer zweiten Spannung ($U_2$) zwischen der ersten Elektrode (4) und der zweiten Elektrode (5) und eines zweiten Stroms ($I_2$) durch das Medium (7) für die zweite Frequenz ($f_2$) des Signals (S) und einer zweiten Impedanz ($Z_2$) aus der zweiten Spannung ($U_2$) und dem zweiten Strom ($I_2$),
- bestimmen und vergleichen einer Phase ($\varphi_1$) der ersten Impedanz ($Z_1$) mit einer Phase ($\varphi_2$) der zweiten Impedanz ($Z_2$),
- bestimmen, wenn die Phase ($\varphi_1$) der ersten Impedanz ($Z_1$) kleiner als die Phase ($\varphi_2$) der zweiten Impedanz ($Z_2$) ist, eines Widerstands (R) des Mediums (7) gemäß einer ersten Formel

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)},$$

- bestimmen, wenn die Phase ($\varphi_1$) der ersten Impedanz ($Z_1$) gleich der oder größer als die Phase ($\varphi_2$) der zweiten Impedanz ($Z_2$) ist, des Widerstands (R) gemäß einer zweiten Formel

$$R = \frac{|Z_1|}{\cos(\varphi_1)}$$

und
- bestimmen einer Leitfähigkeit ($\sigma$) des Mediums (7) unter Verwendung des Widerstands (R) und der Zellkonstanten (k).

**8.** Betriebsverfahren nach Anspruch 7, wobei von der Steuerung (2) ein Durchfluss des Mediums (7) durch das Messrohr (3) durch Ausführen eines magnetisch-induktiven Durchflussmessverfahrens unter Verwendung der ersten Elektrode (4) und der zweiten Elektrode (5) bestimmt wird.

**9.** Betriebsverfahren nach Anspruch 8, wobei beim magnetisch-induktiven Durchflussmessverfahren von der Steuerung (2) ein magnetisches Wechselfeld zum Bestimmen des Durchflusses erzeugt wird, vorzugsweise ein Rechteck-Wechselfeld, und wobei von der Steuerung (2) das Signal (S) in einem transienten Bereich des magnetischen Wechselfelds in die erste Elektrode (4) und die zweite Elektrode (5) eingespeist wird.

**10.** Betriebsverfahren nach einem der Ansprüche 7 bis 9, wobei die Steuerung (2) nach Anspruch 2 ausgebildet ist und/oder von der Steuerung (2) ein Verfahren gemäß einem der Ansprüche 2 bis 6 ausgeführt wird.

**11.** Magnetisch-induktives Durchflussmessgerät (2) mit einer Steuerung (2), einem Messrohr (3), einer ersten Elektrode (4) und einer zweiten Elektrode (5),

wobei die erste Elektrode (4) und die zweite Elektrode (5) derart am Messrohr (3) angeordnet sind, sodass die erste Elektrode (4) und die zweite Elektrode (5) im Betrieb des magnetisch-induktiven Messgerätes (1) in unmittelbarem Kontakt mit einem Medium (7) im Messrohr (7) sind,
wobei die Steuerung (2) zum Bestimmen eines Durchflusses des Mediums (7) durch das Messrohr (3) unter Verwendung der ersten Elektrode (4) und der zweiten Elektrode (5) ausgebildet ist,
wobei die erste Elektrode (4), die zweite Elektrode (5) und das Messrohr (3) eine Messzelle (15) mit einer Zellkonstante (k) zum Bestimmen einer Leitfähigkeit ($\sigma$) des Mediums (7) bilden und wobei die Steuerung (2) zur Ausführung der folgenden Schritte ausgebildet ist:

- Erzeugen eines Signals (S) mit einer ersten Frequenz ($f_1$) und einer zweiten Frequenz ($f_2$) und einspeisen des Signals (S) in die erste Elektrode (4) und die zweite Elektrode (5),
- bestimmen einer ersten Spannung ($U_1$) zwischen der ersten Elektrode (4) und der zweiten Elektrode (5) und eines ersten Stroms ($I_1$) durch das Medium (7) für die erste Frequenz ($f_1$) des Signals (S) und einer ersten Impedanz ($Z_1$) aus der ersten Spannung ($U_1$) und dem ersten Strom ($I_1$),
- bestimmen einer zweiten Spannung ($U_2$) zwischen der ersten Elektrode (4) und der zweiten Elektrode (5) und eines zweiten Stroms ($I_2$) durch das Medium (7) für die zweite Frequenz ($f_2$) des Signals (S) und einer zweiten Impedanz ($Z_2$) aus der zweiten Spannung ($U_2$) und dem zweiten Strom ($I_2$),
- bestimmen und vergleichen einer Phase ($\varphi_1$) der ersten Impedanz ($Z_1$) mit einer Phase ($\varphi_2$) der zweiten Impedanz ($Z_2$),
- bestimmen, wenn die Phase ($\varphi_1$) der ersten Impedanz ($Z_1$) kleiner als die Phase ($\varphi_2$) der zweiten Impedanz ($Z_2$) ist, eines Widerstands (R) des Mediums (7) gemäß einer ersten Formel

$$ R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)} , $$

- bestimmen, wenn die Phase ($\varphi_1$) der ersten Impedanz ($Z_1$) gleich der oder größer als die Phase ($\varphi_2$) der zweiten Impedanz ($Z_2$) ist, des Widerstands (R) gemäß einer zweiten Formel

$$ R = \frac{|Z_1|}{\cos(\varphi_1)} $$

und
- bestimmen einer Leitfähigkeit ($\sigma$) des Mediums (7) unter Verwendung des Widerstands (R) und der Zellkonstanten (k).

**12.** Magnetisch-induktives Durchflussmessgerät (1) nach Anspruch 11, wobei die Steuerung (2) nach Anspruch 2 ausgebildet ist und/oder wobei die Steuerung (2) ausgebildet ist, ein Verfahren gemäß einem der Ansprüche 2 bis 6 oder ein Betriebsverfahren gemäß einem der Ansprüche 8 bis 9 auszuführen.

**Claims**

**1.** Method for determining a conductivity ($\sigma$) of a medium (7) with a controller (2) and a measuring cell (15),

wherein the measuring cell (15) has a cell constant (k), a first electrode (4) and a second electrode (5),
wherein the first electrode (4) and the second electrode (5) are in direct contact with the medium (7), and
wherein the controller (2) carries out the following steps:

- generating a signal (S) with a first frequency ($f_1$) and a second frequency ($f_2$) and feeding the signal (S) to the first electrode (4) and the second electrode (5),
- determining a first voltage ($U_1$) between the first electrode (4) and the second electrode (5) and a first current ($I_1$) through the medium (7) for the first frequency ($f_1$) of the signal (S) and a first impedance ($Z_1$) from the first voltage ($U_1$) and the first current ($I_1$)
- determining a second voltage ($U_2$) between the first electrode (4) and the second electrode (5) and a second current ($I_2$) through the medium (7) for the second frequency ($f_2$) of the signal (S) and a second impedance (Z2) from the second voltage ($U_2$) and the second current ($U_2$)

- determining and comparing a phase ($\varphi_1$) of the first impedance($Z_1$) with a phase ($\varphi_2$) of the second impedance ($Z_2$),
- determining, when the phase ($\varphi_1$) of the first impedance ($Z_1$) is smaller than the phase ($\varphi_2$) of the second impedance ($Z_2$), a resistance (R) of the medium (7) according to a first formula

$$R = \text{Re}(Z_2) - \text{Im}(Z_2) \cdot \frac{\text{Re}(Z_2) - \text{Re}(Z_1)}{\text{Im}(Z_2) - \text{Im}(Z_1)},$$

- determining, when the phase ($\varphi_1$) of the first impedance ($Z_1$) is equal to or greater than the phase ($\varphi_2$) of the second impedance ($Z_2$), the resistance (R) according to a second formula

$$R = \frac{|Z_1|}{\cos(\varphi_1)}$$

and
- determining a conductivity ($\sigma$) of the medium (7) using the resistance (R) and the cell constant (k).

2. Method according to claim 1, wherein the controller (2) comprises leads (13, 14), wherein the leads (13, 14) connect the controller (2) to the first electrode (4) and the second electrode (5), wherein, if the phase ($\varphi_1$) of the first impedance ($Z_1$) is smaller than the phase ($\varphi_2$) of the second impedance ($Z_2$), a lead resistance ($R_L$) of the leads (13, 14) is subtracted from the resistance (R).

3. Method according to claim 1 or 2, wherein the signal (S) comprises a first partial signal with the first frequency ($f_1$) and a second partial signal with the second frequency ($f_2$) and wherein the first partial signal and the second partial signal are superimposed on each other in the time domain.

4. Method according to any one of claims 1 to 3, wherein a quotient of the second frequency ($f_2$) divided by the first frequency ($f_1$) is in a range between 1.8 and 2.2, preferably in a range between 1.9 and 2.1, and particularly preferably is 2.

5. Method according to claim 4, wherein the first frequency ($f_1$) is in a range between 450 Hz and 550 Hz, preferably in a range between 480 Hz and 520 Hz, particularly preferably in a range between 490 Hz and 510 Hz.

6. Method according to any one of claims 1 to 5, wherein the signal (S) comprises a signal voltage (U) and a signal current (I), and wherein the controller (2) carries out the following steps:

- impressing the signal current into the medium (7),
- determining the first voltage ($U_1$) by generating a first square wave signal ($T_1$, $T_1'$) with the first frequency ($f_1$) and multiplying the first square wave signal ($T_1$, $T_1'$) by the signal voltage (U), and
- determining the second voltage ($U_2$) by generating a second square-wave signal ($T_2$, $T_2'$) with the second frequency ($f_2$) and multiplying the second square-wave signal ($T_2$, $T_2'$) by the signal voltage (U).

7. Operating method of a magnetic-inductive flowmeter (1) comprising a controller (2), a measuring tube (3), a first electrode (4) and a second electrode (5),

wherein the first electrode (4) and the second electrode (5) are arranged on the measuring tube (3) in direct contact with a medium (7) in the measuring tube (3),
wherein the controller (2) is arranged to determine a flow rate of the medium (7) through the measuring tube (3) using the first electrode (4) and the second electrode (5)
wherein the first electrode (4), the second electrode (5) and the measuring tube (3) form a measuring cell (15) having a cell constant (k) for determining a conductivity ($\sigma$) of the medium (7), and wherein the controller (2) carries out the following steps:

- generating a signal (S) with a first frequency ($f_1$) and a second frequency ($f_2$) and feeding the signal (S) to the first electrode (4) and the second electrode (5),

- determining a first voltage ($U_1$) between the first electrode (4) and the second electrode (5) and a first current ($I_1$) through the medium (7) for the first frequency ($f_1$) of the signal (S) and a first impedance ($Z_1$) from the first voltage ($U_1$) and the first current ($I_1$),

- determining a second voltage ($U_2$) between the first electrode (4) and the second electrode (5) and a second current ($I_2$) through the medium (7) for the second frequency ($f_2$) of the signal (S) and a second impedance ($Z_2$) from the second voltage ($U_2$) and the second current ($I_2$),

- determining and comparing a phase ($\varphi_1$) of the first impedance ($Z_1$) with a phase ($\varphi_2$) of the second impedance ($Z_2$),

- determining, when the phase ($\varphi_1$) of the first impedance ($Z_1$) is smaller than the phase ($\varphi_2$) of the second impedance ($Z_2$), a resistance (R) of the medium (7) according to a first formula

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)},$$

- determining, when the phase ($\varphi_1$) of the first impedance ($Z_1$) is equal to or greater than the phase ($\varphi_2$) of the second impedance ($Z_2$), the resistance (R) according to a second formula

$$R = \frac{|Z_1|}{\cos(\varphi_1)}$$

and

- determining a conductivity ($\sigma$) of the medium (7) using the resistance (R) and the cell constant (k).

8. Operating method according to claim 7, wherein a flow rate of the medium (7) through the measuring tube (3) is determined by the controller (2) by carrying out a magnetic-inductive flow measurement method using the first electrode (4) and the second electrode (5).

9. Operating method according to claim 8, wherein, in the magnetic-inductive flow measuring method, an alternating magnetic field for deter-mining the flow is generated by the controller (2), preferably a rectangular alternating field, and wherein, in a transient region of the alternating magnetic field, the signal (S) is fed into the first electrode (4) and the second electrode (5) by the controller (2).

10. Operating method according to any one of claims 7 to 9, wherein the controller (2) is configured according to claim 2 and/or a method according to any one of claims 2 to 6 is executed by the controller (2).

11. Magnetic-inductive flowmeter (2) comprising a controller (2), a measuring tube (3), a first electrode (4) and a second electrode (5),

wherein the first electrode (4) and the second electrode (5) are arranged on the measuring tube (3) in such a way that the first electrode (4) and the second electrode (5) are in direct contact with a medium (7) in the measuring tube (7) during operation of the magnetic-inductive measuring device (1),

wherein the controller (2) is adapted to determine a flow rate of the medium (7) through the measuring tube (3) using the first electrode (4) and the second electrode (5)

wherein the first electrode (4), the second electrode (5) and the measuring tube (3) form a measuring cell (15) having a cell constant (k) for determining a conductivity ($\sigma$) of the medium (7), and wherein the controller (2) is designed to carries out the following steps:

- generating a signal (S) with a first frequency ($f_1$) and a second frequency ($f_2$) and feeding the signal (S) into the first electrode (4) and the second electrode (5),

- determining a first voltage ($U_1$) between the first electrode (4) and the second electrode (5) and a first current ($I_1$) through the medium (7) for the first frequency ($f_1$) of the signal (S) and a first impedance ($Z_1$) from the first voltage ($U_1$) and the first current ($I_1$),

- determining a second voltage ($U_2$) between the first electrode (4) and the second electrode (5) and a

second current ($I_2$) through the medium (7) for the second frequency ($f_2$) of the signal (S) and a second impedance ($Z_2$) from the second voltage ($U_2$) and the second current ($I_2$),
- determining and comparing a phase ($\varphi_1$) of the first impedance ($Z_1$) with a phase ($\varphi_2$) of the second impedance ($Z_2$),
- determining, when the phase ($\varphi_1$) of the first impedance ($Z_1$) is smaller than the phase ($\varphi_2$) of the second impedance ($Z_2$), a resistance (R) of the medium (7) according to a first formula

$$R = \mathrm{Re}(Z_2) - \mathrm{Im}(Z_2) \cdot \frac{\mathrm{Re}(Z_2) - \mathrm{Re}(Z_1)}{\mathrm{Im}(Z_2) - \mathrm{Im}(Z_1)},$$

- determining, when the phase ($\varphi_1$) of the first impedance ($Z_1$) is equal to or greater than the phase ($\varphi_2$) of the second impedance ($Z_2$), the resistance (R) according to a second formula

$$R = \frac{|Z_1|}{\cos(\varphi_1)}$$

and
- determining a conductivity ($\sigma$) of the medium (7) using the resistance (R) and the cell constant (k).

12. Magnetic-inductive flowmeter (1) according to claim 11, wherein the controller (2) is designed according to claim 2 and/or wherein the controller (2) is designed to carry out a method according to any one of claims 2 to 6 or an operating method according to any one of claims 8 to 9.


**Revendications**

1. Procédé de détermination d'une conductivité ($\sigma$) d'un milieu (7) à l'aide d'une commande (2) et d'une cellule de mesure (15),

la cellule de mesure (15) comportant une constante de cellule (k), une première électrode (4) et une deuxième électrode (5),
la première électrode (4) et la deuxième électrode (5) étant en contact direct avec le milieu (7) et
la commande (2) effectuant les étapes suivantes :

- générer un signal (S) à une première fréquence ($f_1$) et une deuxième fréquence ($f_2$) et injecter le signal (S) dans la première électrode (4) et la deuxième électrode (5),
- déterminer une première tension ($U_1$) entre la première électrode (4) et la deuxième électrode (5) et un premier courant ($I_1$) à travers le milieu (7) pour la première fréquence ($f_1$) du signal (S) et une première Impédance ($Z_1$) à partir de la première tension ($U_1$) et du premier courant ($I_1$),
- déterminer une deuxième tension ($U_2$) entre la première électrode (4) et la deuxième électrode (5) et un deuxième courant ($I_2$) à travers le milieu (7) pour la deuxième fréquence ($f_2$) du signal (S) et une deuxième Impédance ($Z_2$) à partir de la deuxième tension ($U_2$) et du deuxième courant ($I_2$),
- déterminer et comparer une phase ($\varphi_1$) de la première impédance ($Z_1$) à une phase ($\varphi_2$) de la deuxième impédance ($Z_2$),
- déterminer, lorsque la phase ($\varphi_1$) de la première impédance ($Z_1$) est inférieure à la phase ($\varphi_2$) de la deuxième impédance ($Z_2$), une résistance (R) du milieu (7) selon une première formule

$$R = Re(Z_2) - Im(Z_2) \cdot \frac{Re(Z_2) - Re(Z_1)}{Im(Z_2) - Im(Z_1)},$$

- déterminer, lorsque la phase ($\varphi_1$) de la première impédance ($Z_1$) est égale ou supérieure à la phase ($\varphi_2$) de la deuxième impédance ($Z_2$), la résistance (R) selon une deuxième formule

$$R = \frac{|Z_1|}{cos(\varphi_1)}$$

et

- déterminer une conductivité ($\sigma$) du milieu (7) à l'aide de la résistance (R) et de la constante de cellule (k).

2. Procédé selon la revendication 1, la commande (2) comportant des lignes (13, 14), les lignes (13, 14) reliant la commande (2) à la première électrode (4) et à la deuxième électrode (5), une résistance de ligne ($R_1$) des lignes (13, 14) étant soustraite de la résistance (R) lorsque la phase ($\varphi_1$) de la première impédance ($Z_1$) est inférieure à la phase ($\varphi_2$) de la deuxième impédance ($Z_2$).

3. Procédé selon la revendication 1 ou 2, le signal (S) comportant un premier sous-signal à la première fréquence ($f_1$) et un deuxième sous-signal à la deuxième fréquence ($f_2$) et le premier sous-signal et le deuxième sous-signal étant superposés l'un à l'autre dans le domaine temporel.

4. Procédé selon l'une des revendications 1 à 3, un quotient formé par la deuxième fréquence ($f_2$) divisée par la première fréquence ($f_1$) étant dans une gamme comprise entre 1,8 et 2,2, de préférence dans une gamme comprise entre 1,9 et 2,1 et étant de manière particulièrement préférée égal à 2.

5. Procédé selon la revendication 4, la première fréquence ($f_1$) étant dans une gamme comprise entre 450 Hz et 550 Hz, de préférence dans une gamme comprise entre 480 Hz et 520 Hz, de manière particulièrement préférée dans une gamme comprise entre 490 Hz et 510 Hz.

6. Procédé selon l'une des revendications 1 à 5, le signal (S) ayant une tension de signal (U) et un courant de signal (I) et la commande (2) effectuant les étapes suivantes :

   - injecter le courant de signal dans le milieu (7),
   - déterminer la première tension ($U_1$) en générant un premier signal rectangulaire ($T_1$, $T_1'$) à la première fréquence ($f_1$) et en multipliant le premier signal rectangulaire ($T_1$, $T_1'$) par la tension de signal (U) et
   - déterminer la deuxième tension ($U_2$) en générant un deuxième signal rectangulaire ($T_2$, $T_2'$) à la deuxième fréquence ($f_2$) et en multipliant le deuxième signal rectangulaire ($T_2$, $T_2'$) par la tension de signal (U).

7. Procédé de fonctionnement d'un débitmètre magnéto-inductif (1) comprenant une commande (2), un tube de mesure (3), une première électrode (4) et une deuxième électrode (5),

   la première électrode (4) et la deuxième électrode (5) étant disposées sur le tube de mesure (3) en contact direct avec un milieu (7) dans le tube de mesure (3),
   la commande (2) étant conçue pour déterminer un débit du milieu (7) à travers le tube de mesure (3) à l'aide de la première électrode (4) et de la deuxième électrode (5),
   la première électrode (4), la deuxième électrode (5) et le tube de mesure (3) formant une cellule de mesure (15) ayant une constante de cellule (k) pour déterminer une conductivité ($\sigma$) du milieu (7) et la commande (2) effectuant les étapes suivantes :

   - générer un signal (S) à une première fréquence ($f_1$) et une deuxième fréquence ($f_2$) et injecter le signal (S) dans la première électrode (4) et la deuxième électrode (5),
   - déterminer une première tension ($U_1$) entre la première électrode (4) et la deuxième électrode (4) et un premier courant ($I_1$) à travers le milieu (7) pour la première fréquence ($f_1$) du signal (S) et une première Impédance ($Z_1$) à partir de la première tension ($U_1$) et du premier courant ($I_1$),
   - déterminer une deuxième tension ($U_2$) entre la première électrode (4) et la deuxième électrode (5) et un deuxième courant ($I_2$) à travers le milieu (7) pour la deuxième fréquence ($f_2$) du signal (S) et une deuxième impédance ($Z_2$) à partir de la deuxième tension ($U_2$) et du deuxième courant ($I_2$),
   - déterminer et comparer une phase ($\varphi_1$) de la première impédance ($Z_1$) à une phase ($\varphi_2$) de la deuxième impédance ($Z_2$),
   - déterminer, lorsque la phase ($\varphi_1$) de la première impédance ($Z_1$) est inférieure à la phase ($\varphi_2$) de la deuxième impédance ($Z_2$), une résistance (R) du milieu (7) selon une première formule

$$R = Re(Z_2) - Im(Z_2) \cdot \frac{Re(Z_2) - Re(Z_1)}{Im(Z_2) - Im(Z_1)},$$

- déterminer, lorsque la phase ($\varphi_1$) de la première impédance ($Z_1$) est égale ou supérieure à la phase ($\varphi_2$) de la deuxième impédance ($Z_2$), la résistance (R) selon une deuxième formule

$$R = \frac{|Z_1|}{cos(\varphi_1)}$$

et

- déterminer une conductivité ($\sigma$) du milieu (7) à l'aide de la résistance (R) et de la constante de cellule (k).

8. Procédé de fonctionnement selon la revendication 7, la commande (2) déterminant un débit du milieu (7) à travers le tube de mesure (3) en mettant en œuvre un procédé de mesure de débit magnéto-inductif à l'aide de la première électrode (4) et de la deuxième électrode (5) .

9. Procédé de fonctionnement selon la revendication 8, dans le procédé de mesure de débit magnéto-inductif, la commande (2) générant un champ magnétique alternatif destiné à déterminer le débit, de préférence un champ alternatif rectangulaire, et le signal (S) étant injecté par la commande (2) dans la première électrode (4) et la deuxième électrode (5) dans une zone transitoire du champ magnétique alternatif.

10. Procédé de fonctionnement selon l'une des revendications 7 à 9, la commande (2) étant conçue selon la revendication 2 et/ou un procédé selon l'une des revendications 2 à 6 étant mis en œuvre par la commande (2).

11. Débitmètre magnéto-inductif (2) comprenant une commande (2), un tube de mesure (3), une première électrode (4) et une deuxième électrode (5), la première électrode (4) et la deuxième électrode (5) étant disposées sur le tube de mesure (3) de telle sorte que la première électrode (4) et la deuxième électrode (5) soient en contact direct avec un milieu (7) dans le tube de mesure (7)pendant le fonctionnement du dispositif de mesure magnéto-inductif (1),

la commande (2) étant conçue pour déterminer un débit du milieu (7) à travers le tube de mesure (3) à l'aide de la première électrode (4) et de la deuxième électrode (5),
la première électrode (4), la deuxième électrode (5) et le tube de mesure (3) formant une cellule de mesure (15) ayant une constante de cellule (k) pour déterminer une conductivité ($\sigma$) du milieu (7) et la commande (2) étant conçue pour effectuer les étapes suivantes :

- générer un signal (S) à une première fréquence ($f_1$) et une deuxième fréquence ($f_2$) et injecter le signal (S) dans la première électrode (4) et la deuxième électrode (5),
- déterminer une première tension ($U_1$) entre la première électrode (4) et la deuxième électrode (5) et un premier courant ($I_1$) à travers le milieu (7) pour la première fréquence ($f_1$) du signal (S) et une première Impédance ($Z_1$) à partir de la première tension ($U_1$) et du premier courant ($I_1$),
- déterminer une deuxième tension ($U_2$) entre la première électrode (4) et la deuxième électrode (5) et un deuxième courant ($I_2$) à travers le milieu (7) pour la deuxième fréquence ($f_2$) du signal (S) et une deuxième impédance ($Z_2$) à partir de la deuxième tension ($U_2$) et du deuxième courant ($I_2$),
- déterminer et comparer une phase ($\varphi_1$) de la première impédance ($Z_1$)à une phase ($\varphi_2$) de la deuxième impédance ($Z_2$),
- déterminer, lorsque la phase ($\varphi_1$) de la première impédance ($Z_1$) est inférieure à la phase ($\varphi_2$) de la deuxième impédance ($Z_2$), une résistance (R) du milieu (7) selon une première formule

$$R = Re(Z_2) - Im(Z_2) \cdot \frac{Re(Z_2) - Re(Z_1)}{Im(Z_2) - Im(Z_1)},$$

- déterminer, lorsque la phase ($\varphi_1$) de la première impédance ($Z_1$) est égale ou supérieure à la phase ($\varphi_2$) de la deuxième impédance ($Z_2$), la résistance (R) selon une deuxième formule

$$R = \frac{|Z_1|}{cos(\varphi_1)}$$

et
- déterminer une conductivité ($\sigma$) du milieu (7) à l'aide de la résistance (R) et de la constante de cellule (k).

12. Débitmètre magnéto-inductif (1) selon la revendication 11, la commande (2) étant conçue selon la revendication 2 et/ou la commande (2) étant conçue pour mettre en œuvre un procédé selon l'une des revendications 2 à 6 ou un procédé de fonctionnement selon l'une des revendications 8 à 9.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19844489 A1
- DE 102007014469 A1
- DE 10243748 A1